# EUROPÄISCHE PATENTANMELDUNG

(11) **EP 0 889 525 A2**
(43) Veröffentlichungstag der Anmeldung: **07.01.1999**
(21) Anmeldenummer: 98110999.4
(22) Anmeldetag: 16.06.1998
(51) Int. Cl.: H01L 23/473

(54) **Kühlkörper für Leistungsbauelemente**

(30) Priorität: 01.07.1997 DE 19727912
(71) Anmelder: DAIMLER-BENZ AKTIENGESELLSCHAFT, 70567 Stuttgart (DE)
(72) Erfinder: Heinemeyer, Peter, 14052 Berlin (DE); Baumann, Heinrich, Dr., 76676 Graben-Neudorf (DE); Staiger, Wolfgang, Dr., 70188 Stuttgart (DE)

(57) **Zusammenfassung**

Kühlkörper zum Kühlen von Leistungsbauelementen, wobei Zulauf- und Ablaufstutzen annähernd parallel und mit Abstand in einen Hohlraum münden, in dem sich kreuzende und parallel zueinander verlaufende Strömungskanäle ausgebildet sind und die Strömungskanäle durch rautenförmige Inseln begrenzt sind, wobei die längere Diagonale der Rauten um weniger als 90° gegenüber der Achse der Zulauf- und/oder Ablaufstutzen geneigt ist.

## Beschreibung

Die Erfindung betrifft einen Kühlkörper zum Kühlen von Leistungsbauelementen gemäß dem Oberbegriff des ersten Anspruchs.

Aus der Patentschrift DE-C2 40 17 749 ist ein Kühlkörper bekannt, der von einer Kühlflüssigkeit durchflossen wird, bei dem auf der inneren Oberfläche stoffschlüssig Zapfen senkrecht im Strömungsweg des Kühlmediums angeordnet sind.

Das Problem einer solchen Anordnung besteht darin, daß die Wärmeableitung etwaiger Bauelemente auf den Außenflächen des Kühlkörpers inhomogen ist. Zwischen Zulauf- und Ablaufstutzen wird der Strömungsweg kurzgeschlossen. Es bilden sich deshalb heiße Zonen auf den Außenflächen. Der Wärmewiderstand der Anordnung ist zudem hoch, was insgesamt zu höheren Temperaturen in der Außenfläche des Kühlkorpers führt.

Kühlkörper zum Kühlen von Leistungsbauelementen mit im Innern ausgebildeten Strömungskanälen, welche durch rautenförmige Inseln mit parallelen Diagonalen begrenzt sind, werden z.B. in der SU 860 176 beschrieben. In der AT 383228 B und der DE 196 00 166 A1 sind ebenfalls derartige Kühlkörper offenbart, wobei die längere Diagonale der rautenförmigen Inseln im Innern der Kühlkörper in etwa parallel zur Achse der Zulauf- und Ablaufstutzen verläuft.

Aufgabe der Erfindung ist es, einen Kühlkörper gemäß dem Oberbegriff des ersten Anspruchs anzugeben, der die Strömungsverhältnisse im Kühlkörper verbessert.

Die Aufgabe wird durch die kennzeichnenden Merkmale des ersten Anspruchs gelöst. Weiterführende und vorteilhafte Ausgestaltungen sind den Unteransprüchen und der Beschreibung zu entnehmen.

Der erste Bereich ist in etwa wie ein gleichschenkliges Dreieck mit von den Zulauf- und/oder Ablaufstutzen weg weisender Spitze ausgebildet. Die Basislinie des Dreiecks entspricht dabei in etwa dem Abstand der Zulauf- und Ablaufstutzen.

Außerhalb des Dreiecks ist beidseitig ein zweiter und dritter Bereich ausgebildet, in dem die längere Diagonale der Rauten zwischen 30° und 90° gegenüber der längere Diagonale der Rauten im ersten Bereich geneigt ist. Ganz besonders vorteilhaft ist, die längere Diagonale der Rauten im zweiten und oder dritten Bereich um 60° gegenüber der längere Diagonale der Rauten im ersten Bereich zu neigen und die Neigung im zweiten Bereich dabei gegengleich zur Neigung im dritten Bereich zu wählen. Dadurch wird der Strömungswiderstand in diesen von Zulauf- und Ablaufstutzen entfernten Bereichen vermindert, so daß ein Ausgleich für den längeren Strömungsweg gegeben ist, dort also eine verbesserte Durchströmung erzielt wird.

Zweckmäßig ist, daß im zweiten und dritten Bereich zwischen parallel zueinander stehenden Seitenflanken der Zapfen ausgebildete Strömungskanalachsen senkrecht zur Achsrichtung der Zulauf- und/oder Ablaufstutzen verlaufen.

Eine weitere zweckmäßige Anordnung besteht darin, im ersten und zweiten Bereich, im ersten und dritten Bereich sowie im zweiten und dritten Bereich parallel zueinander verlaufende Strömungskanäle anzuordnen.

Die günstige Wirkung der erfindungsgemäßen Anordnung ist, daß die Strömungsverhältnisse weitgehend homogen über die drei Bereiche sind. Besonders vorteilhaft ist, daß das Druckgefälle zwischen der zulaufseitigen und der ablaufseitigen Hälfte des Kühlkörpers in etwa symmetrisch zur Mittenachse parallel zur Zulauf- und Ablaufstutzenachse ist.

Eine günstige Ausbildungform ist, daß der Kühlkörper aus einem Isolatormaterial gebildet ist, bevorzugt aus einem hochwärmeleitfähigen Isolator, besonders bevorzugt Aluminiumnitrid.

Eine weitere günstige Ausbildungform ist, daß der Kühlkörper aus elektrisch leitfähigem Material, insbesondere Metall, gebildet ist oder metallische Bereiche aufweist.

Im folgenden sind die Merkmale, soweit sie für die Erfindung wesentlich sind, eingehend erläutert und anhand einer Figur näher beschrieben. Die Figur zeigt die prinzipielle Anordnung der rautenförmigen Inseln zwischen den Strömungskanälen.

Der Kühlkörper ist bevorzugt aus einen hochwärmeleitfähigen Material gebildet und kann auch aus elektrisch leitfähigem Material, insbesondere aus Metall, gebildet sein. Bevorzugt ist der Kühlkörper aus einem Isolator, besonders bevorzugt aus Aluminiumnitrid (AlN) gebildet. Die erfindungsgemäße Anordnung hat den Vorteil, daß die Herstellung insbesondere mittels Frästechnik oder Preßtechnik besonders einfach ist. In den folgenden Erläuterungen sind im wesentlichen AlN-Kühlkörper beschrieben, die erfindungsgemäße Anordnung ist jedoch nicht auf dieses Material beschränkt. Ist eine große elektrische Isolierfähigkeit notwendig, kann der Kühlkörper vorzugsweise aus Isolator-Teilen, wie z.B. Aluminiumnitrid, Siliziumkarbid, Aluminiumoxid, Berylliumoxid, Siliziumoxid oder aus Schichtkörpern gebildet sein, die mit gut wärmeleitenden Beschichtungen versehen sind, z.B. aus der obengenannten Gruppe von Isolatoren oder Diamant.

Der Kühlkörper 1 weist vorzugsweise in etwa die Form einer flachen Dose auf, welche in ihrem Innern Zapfen 2, welche als rautenförmige Inseln zwischen den Strömungskanälen 3 angeordnet sind, aufweist. Die Dose kann rund oder eckig ausgebildet sein. Die obere und/oder untere äußere Flachseite kann elektronische Leistungsbauelemente zum Kühlen tragen oder aufnehmen. Die Dose kann zwei- oder mehrteilig ausgebildet sein. Vorzugsweise sind die Zapfen 2 stoffschlüssig zumindest mit einer der inneren Oberflächen der Flachseiten verbunden. Dies vereinfacht die Herstellung der Dose und begünstigt den Wärmedurchgang in das Kühlmedium.

Seitlich sind die Zulauf- und Ablaufstutzen 4, 5 angeordnet, bevorzugt auf derselben Seite der Dose mit einem Abstand von weniger als dem Dosendurchmesser bei einer runden Dose oder mit einem Abstand von weniger oder gleich der Seitenlänge der Dose.

Vorteilhaft ist eine mittlere Zapfendichte von 2-7 Zapfen/cm², insbesonders 4-6 Zapfen/cm², da bei einer derartigen Dichte die Werkzeuge bei einer etwaigen Keramik-Prozeßtechnik, insbesondere Preßtechnik und/oder Frästechnik für den Kühlkörper noch gut handhabbar sind. Die aus der Zapfendichte resultierende relativ geringe Kanalbreite der Strömungskanäle 3, die etwa 1/1 bis 1/5 der Zapfenbreite beträgt, ist vorteilhaft für die Strömungsgeschwindigkeit des Kühlmediums. Eine günstige Anordnung kann einen geringen Warmewiderstand von z.B. nur 20 K/kW bei einseitiger Belastung aufweisen. Günstige Abmessungen sind Kanalbreiten im Bereich von 1-2 mm, insbesondere 1,5-2 mm und/oder Rautenbreiten (Abstand zwischen parallelen Kanten) im Bereich von 2-5 mm, insbesondere 3-4 mm.

Die Rautenform der Zapfen 2 ist besonders strömungsgünstig, da sich bei einer Anströmrichtung parallel zur längeren Rauten-Diagonale an der angeströmten Spitze des Zapfens kein Staupunkt ausbilden kann. Stattdessen wird die Strömung des Kühlmediums geteilt und kann den Zapfen 2 umströmen und kühlen. Die Umströmung der Rauten ist dann besonders vorteilhaft, wenn der Öffnungswinkel der angeströmten vorderen Spitze jeder Raute zwischen 40° und 60°, insbesondere zwischen 46°-55°, liegt, da die Strömungsgeschwindigkeit um die Raute dann maximal, bzw. die Überströmlänge klein ist. Bei größeren Winkeln verschlechtert die Ausbildung von Staupunkten an der Anströmseite der Rauten die Umströmung, bei geringeren Winkeln verringert sich die mechanische Stabilität der umströmten Rauten. Außerdem ist die Überströmlänge bei einer vorgegebenen günstigen Rautendichte zu groß und verschlechtert den Wärmeabfluß aus der Raute.

Die Rauten sind zwischen Zulauf- und Ablaufstutzen 4, 5 in einem ersten Bereich 6 so angeordnet, daß die längere Diagonale 9 der in etwa parallel zur Achse der Zulauf- und Ablaufstutzen verläuft. Der erste Bereich 6 ist in etwa wie ein gleichschenkliges Dreieck mit von den Zulauf- und/oder Ablaufstutzen 4, 5 weg weisender Spitze ausgebildet, wobei die Basislinie des Dreiecks in etwa dem Abstand der Zulauf- und Ablaufstutzen 4, 5 entspricht.

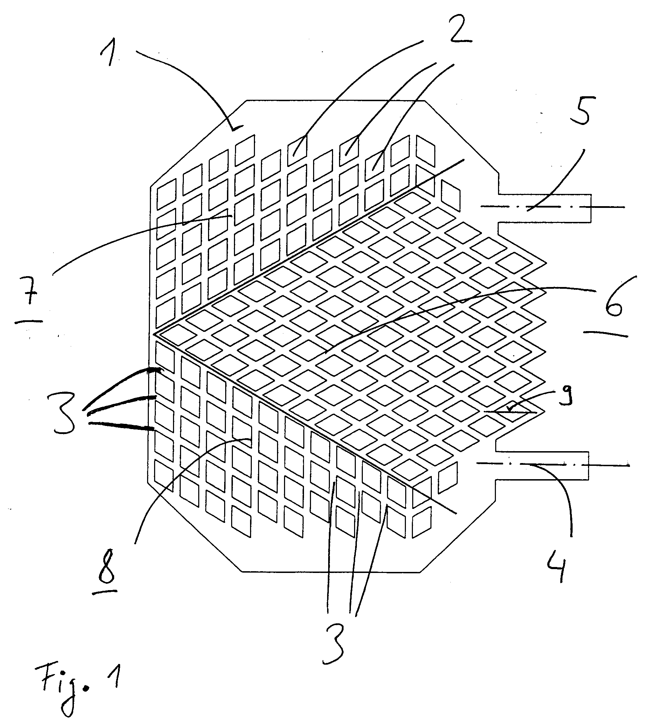

Außerhalb des Dreiecks ist beidseitig einen zweiten und dritten Bereich 7, 8 ausgebildet, in dem die längere Diagonale 9 der Rauten zwischen 30° und 90° gegenüber der längeren Diagonalen 9 der Rauten 2 im ersten Bereich geneigt ist. Ganz besonders vorteilhaft ist, die längere Diagonale 9 der Rauten im zweiten und/oder dritten Bereich um 60° gegenüber der längeren Diagonalen der Rauten 2 im ersten Bereich zu neigen. Dies ist in Fig. 1 dargestellt. Der Strömungswiderstand für einen längeren Strömungsweg im zulauffernen Bereich des Kühlkörpers 1, welcher nicht auf einer direkten Verbindungslinie zwischen Zulauf- und Ablaufstutzen 4, 5 liegen, wird dadurch vorteilhaft reduziert.

Zweckmäßig ist, daß im zweiten und dritten Bereich 7, 8 Strömungskanalachsen 3 senkrecht zur Achsrichtung der Zulauf- und/oder Ablaufstutzen 4, 5 verlaufen. Erfindungsgemäß sind im ersten und zweiten Bereich 6, 7, im ersten und dritten Bereich 6, 8 sowie im zweiten und dritten Bereich 7, 8 parallel zueinander verlaufende Strömungskanäle 3 angeordnet.

Die günstige Wirkung der erfindungsgemäßen Anordnung ist, daß die Strömungsverhältnisse weitgehend homogen über die drei Bereiche 6, 7, 8 sind. Besonders vorteilhaft ist, daß die Isobaren der Kühlmittel-Durchströmung zwischen der zulaufseitigen und der ablaufseitigen Hälfte des Kühlkorpers 1 in etwa symmetrisch zur Mittenachse parallel zur Zulauf- und Ablaufstutzenachse 4, 5 sind. In der zulaufseitigen Hälfte herrscht Hochdruck, in der ablaufseitigen Hälfte herrscht Niederdruck. In der in Fig. 1 dargestellten Anordnung liegt die gedachte Grenzlinie zwischen Hoch- und Niederdruck in etwa in der Mitte der Anordnung. Damit ist sichergestellt, daß das Kühlmedium im wesentlichen homogen von der Zulauf- zu der Ablaufseite des Kühlkörpers 1 strömt.

Die Strömungsgeschwindigkeiten in den Strömungskanälen 3 sind ebenfalls sehr homogen und weichen nur geringfügig voneinander ab.

Grundsätzlich ist die Wärmeabfuhr dann optimal, wenn die Kühlmittelgeschwindigkeit so hoch ist, daß sich eine vollständig turbulente Strömung ausbildet. Es zeigt sich aber, daß bei derart hohen Geschwindigkeiten das Kühlmittel den Kühlkörper durch Erosion beschädigt.

Es ist günstig, wenn der minimale Wärmeübergangskoeffizient α des erfindungsgemäßen Kühlkörpers nicht unter 3000 W/(m² K) liegt. Bei geringeren Werten von α ist die Kühlung unzureichend. Für Wasser als etwaiges Kühlmedium ergibt sich daraus z.B. bei 1 kW Verlustleistung eine minimale Strömungsgeschwindigkeit von 0,1 m/s. Zweckmäßig ist, daß eine minimale Strömungsgeschwindigkeit von ca. 0,1 m/s nicht unterschritten wird. In einem erfindungsgemäßen Kühlkörper 1 gelingt es leicht, mit ca. 3 l/min eine Strömungsgeschwindigkeit zwischen den Rauten 2 deutlich über dem Minimalwert von 0,1 m/s zu erhalten, insbesondere eine Geschwindigkeit, die doppelt so groß ist. Als obere Grenze der Strömungsgeschwindigkeit darf diejenige Kühlmittelgeschwindigkeit nicht überschritten werden, ab welcher der Kühlkörper 1 abrasiv beschädigt wird. Für Aluminiumnitrid liegt diese Grenze z.B. bei etwa 1 m/s, bei Aluminium bei etwa 1,5 m/s.

Obwohl die Strömung des Kühlmediums, z.B. Wasser, noch laminar ist, gelingt mit dem erfindungsgemäßen Kühlkörper eine deutliche Reduktion des Wärmewiderstands. Der Wärmewiderstand liegt deutlich unterhalb von 30 K/kW. Für die genannten Daten des Beispiels liegt der Wert z.B. bei 20 K/kW. Die genauen Zahlenwerte, welche sich jeweils ergeben, sind von der Auslegung für die jeweilige Anwendung abhängig.

## Patentansprüche

1. Kühlkörper zum Kühlen von Leistungsbauelementen, wobei Zulauf- und Ablaufstutzen annähernd parallel und mit Abstand in einen Hohlraum münden, in dem sich kreuzende und parallel zueinander verlaufende Strömungskanäle ausgebildet sind und die Strömungskanäle durch rautenförmige Inseln (2) begrenzt sind, deren längere Diagonale (9) in etwa parallel zur Achse der Zulauf- und Ablaufstutzen (4, 5) verläuft,
dadurch gekennzeichnet,
- daß der Kühlkörper einen ersten Bereich (6) aufweist, der in etwa wie ein gleichschenkliges Dreieck mit von den Zulauf- und Ablaufstutzen (4, 5) weg weisender Spitze ausgebildet ist,
- daß die Basis des Dreiecks in etwa dem Abstand der Zulauf- und Ablaufstutzen (4,5) entspricht, und
- daß außerhalb des Dreiecks beidseitig ein zweiter und dritter Bereich (7, 8) ausgebildet ist, in dem die längere Diagonale (9) der Rauten (2) zwischen 30° und 90° gegenüber der längeren Diagonalen der Rauten im ersten Bereich (6) geneigt ist.

2. Kühlkörper nach Anspruch 1, dadurch gekennzeichnet,
daß die längere Diagonale (9) der Rauten (2) im zweiten und oder dritten Bereich (7, 8) um 60° gegenüber der längeren Diagonalen (9) der Rauten (2) im ersten Bereich (6) geneigt ist.

3. Kühlkörper nach Anspruch 1 oder 2, dadurch gekennzeichnet,
daß im zweiten und dritten Bereich (7, 8) Strömungskanalachsen (3) senkrecht zur Achsrichtung der Zulauf- und Ablaufstutzen (4, 5) verlaufen.

4. Kühlkörper nach einem oder mehreren der vorangegangenen Ansprüche,
dadurch gekennzeichnet,
daß im ersten und zweiten Bereich (6, 7) parallel zueinander verlaufende Strömungskanäle (3) verlaufen.

5. Kühlkörper nach einem oder mehreren der vorangegangenen Ansprüche,
dadurch gekennzeichnet,
daß im ersten und dritten Bereich (6, 8) parallel zueinander verlaufende Strömungskanäle (3) verlaufen.

6. Kühlkörper nach einem oder mehreren der vorangegangenen Ansprüche,
dadurch gekennzeichnet,
daß im zweiten und dritten Bereich (7, 8) parallel zueinander verlaufende Strömungskanäle (3) verlaufen.

7. Kühlkörper nach einem oder mehreren der vorangegangenen Ansprüche,
dadurch gekennzeichnet,
daß der Kühlkörper (1) aus einem elektrisch isolierenden Material gebildet ist.

8. Kühlkörper nach Anspruch 7,
dadurch gekennzeichnet,
daß der Kühlkörper (1) aus Aluminiumnitrid gebildet ist.

9. Kühlkörper nach einem oder mehreren der Ansprüche 1 bis 6,
dadurch gekennzeichnet,
daß der Kühlkörper (1) aus einem elektrisch leitfähigen Material gebildet ist.

10. Kühlkörper nach Anspruch 7 oder 8,
dadurch gekennzeichnet,
daß der Kühlkörper (1) metallische Bereiche aufweist.
